# EUROPEAN PATENT SPECIFICATION

(11) **EP 1 394 128 B1**
(45) Date of publication and mention of the grant of the patent: **10.10.2012**
(21) Application number: 03019414.6
(22) Date of filing: 28.08.2003
(51) Int. Cl.: C03C 23/00

(54) **Optical apparatus**
OptischeVorrichtung
Dispositif optique

(30) Priority: 29.08.2002 JP 2002251346
(43) Date of publication of application: 03.03.2004
(73) Proprietor: FUJIKURA LTD., Kohtoh-ku, Tokyo (JP)
(72) Inventor: Nakatate, Kenichi, Sakura-shi, Chiba-ken, (JP); Tsumanuma, Takashi, Sakura-shi, Chiba-ken, (JP)
(74) Representative: Sawodny, Michael-Wolfgang

(56) References cited:
- EP-A- 0 691 312
- EP-A- 0 867 774

## Description

### BACKGROUND OF THE INVENTION

### Field of the Invention

The present invention relates to optical apparatuses such as semiconductor exposure devices, spectroscopes, and the like in which high energy light such as ultraviolet light is employed.

### Background Art

In a semiconductor exposure device, ultraviolet light having high energy, such as a KrF excimer laser beam or an ArF excimer laser beam for example, may be employed. When such an ultraviolet light is employed, in general, fluorite or synthetic silica that is superior in penetration characteristics in the ultraviolet light band is selected as material for forming optical elements included in the semiconductor exposure device.

However, when ultraviolet light having high energy, in particular, a KrF excimer laser beam or an ArF excimer laser beam is emitted on optical elements such as a lens, an optical fiber, and the like, which are made of synthetic silica, defects may be produced in the molecular structure of the synthetic silica due to the effects of light energy. Such defects may form colored defects by which light passing through the optical elements may undesirably become colored, and light transmissivity of the optical elements may be decreased. Moreover, compaction may occur in the optical elements due to such defects by which the optical elements may have distortions therein.

In order to reduce such defects in the synthetic silica, a method, in which hydrogen is impregnated into the synthetic silica, has been proposed. In this method, hydrogen is impregnated into the synthetic silica by immersing optical elements of synthetic silica in an atmosphere containing hydrogen gas. The defects in the synthetic silica can be reduced in such a manner that the defects react with hydrogen so that more stable bonds such as Si-OH bonds, Si-H bonds, or the like are formed.

However, synthetic silica generally includes defect precursors which could be converted into defects when energy is applied, and which cannot be reduced by the effects of hydrogen, because such defect precursors do not react with hydrogen; therefore, further defects may be produced from the defect precursors when ultraviolet light having high energy is emitted thereon. Moreover, when radiation energy per unit time is very high, even molecular chains in the normal network structure of silica may be broken, which may lead to further defects.

Even when such further defects are produced, light transmissivity is not decreased as long as hydrogen is contained in the synthetic silica because such defects are converted into stable bonds due to the effects of hydrogen. However, when the hydrogen concentration in the synthetic silica is decreased as hydrogen is gradually consumed and hydrogen diffuses into the exterior, the defects can no longer be converted into stable bonds. As a result, because defects increase, the light transmissivity may be decreased so that transmission loss is increased, and distortion due to compaction may occur.

Other methods to reduce such defects have also been proposed, in which fluorine is doped in the synthetic silica, or chlorine radical concentration is decreased; however, even when such methods are employed, the defects cannot be sufficiently reduced; therefore, as in the above-mentioned case, the light transmissivity may be decreased so that transmission loss is increased, and distortion due to compaction may occur.

EP-A-0867774 discloses an optical apparatus comprising a container filed with hydrogen and in which lenses are accommodated. The lenses are aligned with light transmission window. Hydrogen can be flushed through the container using check valves.

EP-A-06913212 discloses a method for producing a synthetic silica glass for use with vacuum ultraviolet light comprises the steps of: (a) producing a soot perform; (b) heating the soot perform in an atmosphere containing fluorine to obtain a fluorine-doped soot perform; (c) consolidating the fluorine-doped soot perform to obtain a fluorine-doped synthetic silica glass; and (d) heating the fluorine-doped synthetic silica glass in an atmosphere containing hydrogen gas to obtain a synthetic silica glass doped with fluorine and hydrogen molecules.

### SUMMARY OF THE INVENTION

In view of the above circumstances, an object of the present invention is to provide an optical apparatus in which the defects in silica that forms optical element(s) included in the optical apparatus are held at a low level even when high energy light such as ultraviolet light is emitted over a long period, so that increase in transmission loss can be prevented, and so that the optical element(s) can be prevented from having distortions.

In order to achieve the object, the present invention provides an optical apparatus including, a container filled with a gas containing hydrogen, and an optical element of silica glass which is accommodated in the container according to claim 1, as well as a method of irradiating an optical element according to claim 8.

In the above optical apparatus, the optical element may preferably be subjected to a heat treatment in a hydrogen atmosphere before being accommodated in the container. The pressure in the hydrogen atmosphere may preferably be set in a range from 98.1 KPa to 49.0 MPa (1 to 500 kgf/cm²), and the temperature in the hydrogen atmosphere may preferably be set in a range from 80 to 500°C.

In the above optical apparatus, the hydrogen concentration of the gas containing hydrogen may preferably be set to be less than 4% by volume.

In the above optical apparatus, the container may be provided with a light transmission window. The light transmission window may be formed as a lens.

In the above optical apparatus, the container may be provided with a shut-off valve or a check valve which is connectable to an external element.

In the above optical apparatus, the gas containing hydrogen may be allowed to flow through the container.

In the above optical apparatus, the optical element includes at least one of a lens, an optical fiber, a mirror, a prism, an optical filter, and a reticle.

In the above optical apparatus, the gas containing hydrogen may be pure hydrogen.

### BRIEF DESCRIPTION OF THE DRAWINGS

FIG. 1 is a schematic diagram showing an embodiment of an optical apparatus according to the present invention.
FIG. 2 is a schematic diagram showing another embodiment of an optical apparatus according to the present invention.
FIG. 3 is a cross-sectional view showing another embodiment of an optical apparatus according to the present invention.
FIG. 4 is a cross-sectional view showing another embodiment of an optical apparatus according to the present invention.
FIG. 5 is a flow chart expressing an embodiment of the invention in method form.

### DETAILED DESCRIPTION OF THE PREFERRED EMBODIMENTS

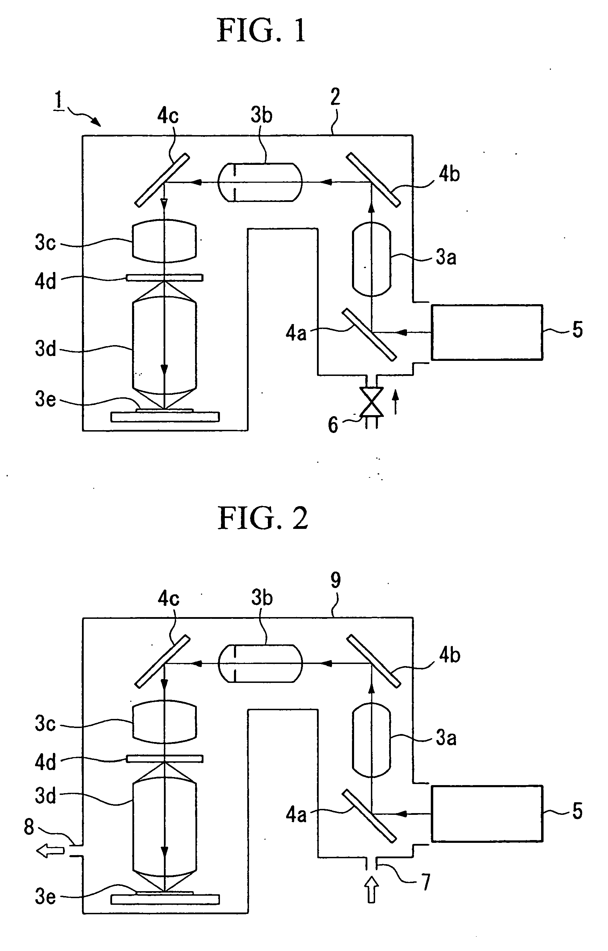

An embodiment of an optical apparatus according to the present invention will be explained below with reference to FIG. 1. An optical apparatus 1 in the present embodiment includes a sealed container 2 filled with a gas containing hydrogen. Lenses 3a, 3b, 3c, and 3d as optical elements of silica glass are accommodated in the sealed container 2. In the sealed container 2, an excimer laser beam emitted from a light source 5 is to be irradiated on a workpiece 3e via the lenses 3a, 3b, 3c, and 3d, mirrors 4a, 4b, and 4c, and a filter 4d. The sealed container 2 is provided with a check valve 6 which is connectable to an external element. Here, the silica glass may be a pure silica glass (SiO₂), a germanium doped silica glass (GeO₂-SiO₂), a fluorine doped silica glass (F-SiO₂), a boron doped silica glass (B₂O₃-SiO₂), a phosphorus doped silica glass, a titanium doped silica glass (TiO₂-SiO₂), a sodium doped silica glass (Na₂O-SiO₂), a silica glass having a chlorine radical, or a silica glass having a hydroxy radical. The excimer laser beam preferably emits coherent ultraviolet light, and may be, for example, a KrF excimer laser beam (having a wavelength of approximately 248 nm), an ArF excimer laser beam (having a wavelength of approximately 193 nm), a F₂ excimer laser beam (having a wavelength of approximately 157 nm), or a XeCl excimer laser beam (having a wavelength of approximately 301 nm). The light source 5 may be accommodated within the container, or outside the container 2.

The lenses 3a, 3b, 3c, and 3d may preferably be subjected to a heat treatment in a hydrogen atmosphere, in which pressure is set in a range from 1 to 500 kgf/cm² (from 98 to 49,000 kPa), and temperature is set in a range from 80 to 500°C, before being accommodated in the sealed container 2. The pressure in the hydrogen atmosphere may preferably be set in a range from 300 to 500 kgf/cm² (from 29,400 to 49,000 kPa) when higher resistance against ultraviolet light for the lenses 3a, 3b, 3c, and 3d is desired, and when a container for accommodating the hydrogen atmosphere has sufficient pressure resistance. The pressure in the hydrogen atmosphere may be set to be less than 100 kgf/cm² (9,800 kPa) when an ordinary equipment (container) is employed. By the heat treatment in the hydrogen atmosphere under the above conditions, hydrogen is impregnated into synthetic silica, and thereby defects contained in the molecular structure of synthetic silica can be reduced.

The sealed container 2, in which optical elements such as lenses are accommodated, has sufficient pressure resistance, and may preferably be made of metal such as stainless steel or the like. The partial pressure of hydrogen may preferably be set in a range from 0.01 to 500 kgf/cm² (from 0.98 to 49,000 kPa). When the partial pressure of hydrogen is set in this range, hydrogen molecules can be sufficiently and effectively impregnated into synthetic silica that forms the optical elements. The partial pressure of hydrogen may preferably be set in a range from 300 to 500 kgf/cm² (from 29,400 to 49,000 kPa) when higher resistance against ultraviolet light of the lenses 3a, 3b, 3c, and 3d is desired, and when the sealed container 2 has sufficient pressure resistance. The pressure in the hydrogen atmosphere may be set to be less than 10 kgf/cm² (980 kPa) when safety and ease of handling are specifically desired.

The gas containing hydrogen filling the sealed container 2 preferably contains gas or gases other than hydrogen gas. Such gas or gases other than hydrogen gas may include a rare (Noble) gas, such as a helium gas, a neon gas, or an argon gas, an inert gas, such as a nitrogen gas or a carbon dioxide gas, a noncombustible gas, a nonexplosive gas, or a gas which does not support combustion, such as a chlorofluorocarbon gas. When such gas is included, the hydrogen concentration in the sealed container 2 is preferably be set to less than 4% by volume. The condition in which the hydrogen concentration is set to be less than 4% by volume is outside of the range in which hydrogen could explode (i.e., 4 to 75% by volume).

The check valve 6 is provided for introducing the gas containing hydrogen into the sealed container 2. If a valve such as the check valve 6 is provided, the gas containing hydrogen can be easily introduced into the sealed container 2, and in particular, it is easy to reintroduce the gas containing hydrogen. Normally, when the gas containing hydrogen is supplied through the check valve 6, the gas containing hydrogen is not continuously supplied.

According to the optical apparatus 1 of the present embodiment, even when defects are produced in the synthetic silica that forms the optical elements due to ultraviolet light emitted from the light source 5, the defects can be converted into stable bonds due to the effects of hydrogen contained in the synthetic silica; therefore, the defects contained in the molecular structure of synthetic silica can be reduced. Moreover, because hydrogen is continuously supplied to synthetic silica from the gas containing hydrogen in the sealed container 2, the hydrogen concentration in the synthetic silica will not decrease even though time passes and hydrogen therein is consumed. Accordingly, because the defects can be converted into stable bonds over a long period, light transmissivity will not decrease over a long period, and an increase in transmission loss can be prevented. Furthermore, because compaction can be prevented by reducing the defects, the optical elements of synthetic silica can be prevented from having distortion therein over a long period.

The present invention is not limited to the above embodiment. In the above embodiment, the sealed container 2 is used as a container, and the gas containing hydrogen is not continuously supplied through the check valve 6; however, for example, the gas containing hydrogen may be continuously supplied. An embodiment in which a gas containing hydrogen is continuously supplied is shown in FIG. 2. In this embodiment, optical elements 3a, 3b, 3c, and 3d are accommodated in a container 9 which is provided with an inlet 7 for the gas containing hydrogen and an outlet 8 for the gas containing hydrogen. The gas containing hydrogen is continuously supplied through the inlet 7, and the gas containing hydrogen is allowed to flow through the container 9. In this case, the hydrogen concentration in the container 9 can be regulated; therefore, the defects contained in the optical elements of synthetic silica can be stably minimized over a long period. The light source 5 may be accommodated within the container, or outside the container 9.

As another embodiment, the sealed container 2 may be provided with a shut-off valve. The shut-off valve is provided instead of, or in addition to, the check valve 6. Moreover, a container may be provided with neither a shut-off valve nor a check valve. In the case in which no valve is provided, hydrogen can be contained in the container by accommodating optical elements in the container in an atmosphere containing hydrogen gas, and then sealing the container.

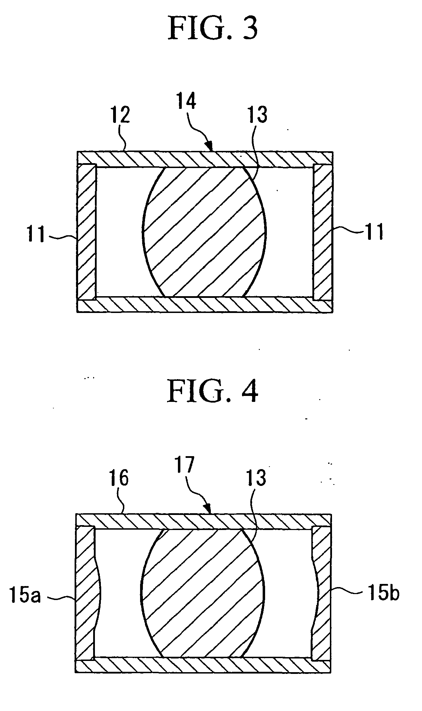

In the above-embodiments, a plurality of lenses are accommodated in a single container; however, a single lens may be accommodated in a single container. An embodiment in which a single lens is accommodated in a single container is shown in FIG. 3. FIG. 3 is a cross-sectional view showing an optical apparatus according to the present embodiment, which is taken along the light path in the optical apparatus. In this embodiment, an optical apparatus 14 includes a container 12 which is provided at both ends thereof with light transmission windows 11, respectively, and a lens 13 as an optical element which is accommodated in the container 12. In this case, light emitted from an external light source (not shown) passes through the lens 13 via the light transmission window. According to the optical apparatus 14, a space in which hydrogen should be contained is minimized; therefore, the amount of hydrogen required is reduced. Note that the light transmission windows 11 are transparent elements which allow light to pass through, and may be of synthetic silica, magnesium fluoride, or the like.

Furthermore, as shown in FIG. 4 showing an optical apparatus 17 as another embodiment, lenses 15a and 15b may be employed as light transmission windows so that a container 16 acts as a lens cell. According to the present embodiment, the optical apparatus 17 is compact because the container 16 acts as a lens cell.

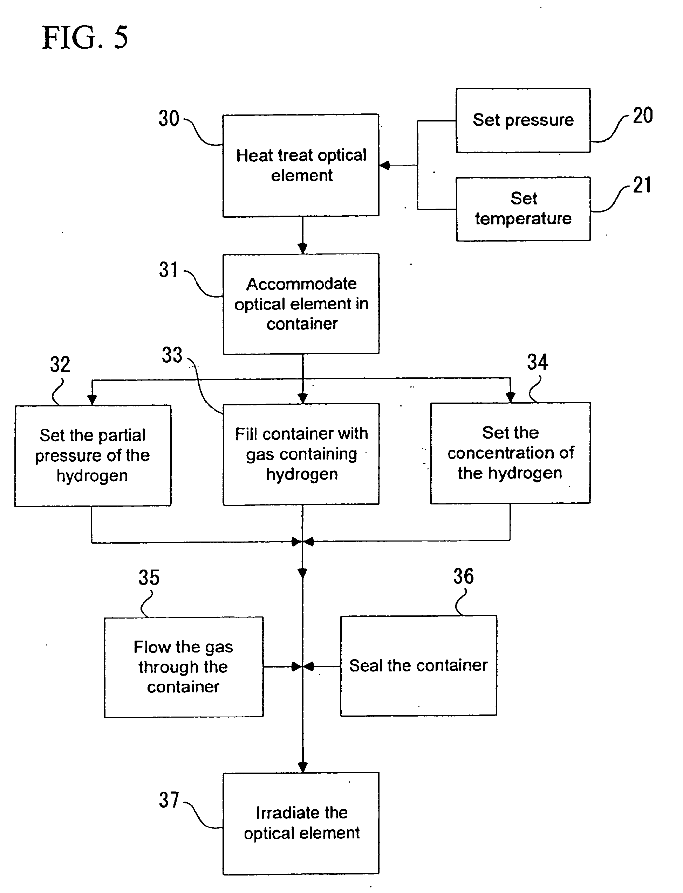

Furthermore, FIG. 5 illustrates an embodiment of the invention as a method. As a first step, the optical element is heat treated in a hydrogen atmosphere (step 30). The step of heat treating includes steps of setting the pressure of the hydrogen atmosphere to be 98.1 KPa to 49.0MPa (1 to 500 kgf/cm²), and setting the temperature of the hydrogen atmosphere to be 80 to 500 °C. After heat treating, the optical element is accommodated in the container (step 31). The container is then filled with gas containing hydrogen (step 33), setting the partial pressure of the hydrogen to be in a range of 981 KPa to 49.0MPa (0.01 to 500 kgf/cm²) (step 32). Preferably, the concentration of the hydrogen in the container is set to be less than 4% by volume (step 34). Thereafter, the gas can be flowed through the container while maintaining pressure (step 35). The container can also be sealed (step 36). Light is then irradiated on the optical element (step 37).

As explained above, according to the present invention, a container which houses optical elements is filled with a gas containing hydrogen, and hydrogen is supplied from the gas containing hydrogen to silica that forms the optical elements; therefore, the hydrogen concentration in silica will not decrease even though ultraviolet light having high energy, such as a KrF excimer laser beam, an ArF excimer laser beam, or the like, is emitted on the optical elements, the defects in silica can be converted into stable bonds over a long period. As a result, the light transmissivity of the optical elements will not decrease, increase in transmission loss can be prevented, and the optical elements can be prevented from having distortions over a long period, and thus long term reliability of the optical elements can be improved.

The above-mentioned effects can be anticipated not only in the case in which ultraviolet light is emitted, but also in the case in which the optical elements are exposed to high energy radiation, such as gamma radiation, neutron radiation, or the like, which tends to produce defects in the optical elements. Even under such conditions, the defects in silica can be minimized, and the optical elements can be prevented from being degraded.

## Claims

1. An optical apparatus comprising:
a container (2) filled with a gas containing hydrogen;
an optical element (3a, 3b. 3c, 3d) of silica glass, accommodated in the container (2); and
a light source (5) emitting coherent light, **characterized by** the following features: the hydrogen has a partial pressure of 981Pa to 49.0M Pa (0.01 to 500 kgf/cm²) ; the optical element (3a, 3b, 3c, 3d) and said light source (5) are aligned so that the coherent light emitted from the light source (5) is incident upon the optical element (3a, 3b, 3c, 3d), and
the eight source (5) is an excimer laser, emitting ultraviolet eight.

2. An optical apparatus according to claim 1, wherein the hydrogen concentration of the gas containing hydrogen is set to be less than 4% by volume.

3. An optical apparatus according to claim 1, wherein said container (2) further comprises a valve (6), the valve (6) being of a construction for connection to an external element to supply at least hydrogen from the external element into said container (2).

4. An optical apparatus according to claim 3, wherein the valve (6) is selected from the group consisting of a check valve and a shut-off valve.

5. An optical apparatus according to claim 1, wherein the container (9) further comprises at least an inlet (7) and at least an outlet (8), wherein the gas containing hydrogen flows through the container (9) from said at least an inlet (7) to the at least an outlet (8).

6. An optical apparatus according to claim 1, wherein the gas containing hydrogen is pure hydrogen.

7. An optical apparatus according to claim 1, wherein the optical element (3a, 3b, 3c. 3d) includes at least one of a lens, an optical fiber, a mirror, a prism, an optical filter, and a reticle.

8. A method of irradiating an optical element (3a, 3b, 3c, 3d) with ultraviolet light while protecting the optical element (3a, 3b, 3c, 3d) comprising silica glass from radiation-friduced defects, comprising steps of:
heat treating the optical element (3a, 3b, 3c, 3d) in a hydrogen atmosphere;
**characterized by** the following steps:
accommodating the optical element (3a, 3b, 3c, 3d) in a container (2) after heat treatment;
filling the container (2) with a gas containing hydrogen after accommodating the optical element (3a, 3b, 3c, 3d);
setting the partial pressure of the hydrogen in the filled container (2) to be in a range of 981Pa to 49.MPa (0.01 to 500 kgf/cm²), and
irradiating the optical element (3a, 3b, 3c, 3d) in the filled container (2) with ultraviolet light.

9. A method according to claim 8, wherein said step of heat treating includes contemporary steps of:
setting a pressure of the hydrogen atmosphere to be 98.1KPa to 49.0MPa (1 to 500 kgf/cm²);
setting a temperature of the hydrogen atmosphere to be 80 to 500 °C.

10. A method according to claim 8, further comprising a step of:
flowing the gas containing hydrogen through the container (2), after the step of filling the container (2), while maintaining the hydrogen at the partial pressure of 981 Pa to 49.0 MPa (0.0 to 500 kgf/cm²)

11. A method according to claim 8, further comprising a step of:
sealing the container (2) after the step of filling the container (2).

12. A method according to claim 8, further comprising a step of:
setting the concentration of the hydrogen filling the container (2) to be less than 4% by volume.

## Patentansprüche

1. Optische Vorrichtung, umfassend:
Einen Behälter (2), der mit einem wasserstoffhaltigen Gas gefüllt ist,
ein optisches Element (3a, 3b, 3c, 3d) aus Quarzglas, das in dem Behälter (2) aufgenommen ist, und
eine Lichtquelle (5), die kohärentes Licht emittiert,
**gekennzeichnet durch** die folgenden Merkmale:
der Wasserstoff hat einen Partialdruck von 981 Pa bis 49,0 MPa (0,01 bis 500 kgf/cm²);
das optische Element (3a, 3b, 3c, 3d) und die Lichtquelle (5) sind so ausgerichtet, dass das von der Lichtquelle (5) emittierte, kohärente Licht auf das optische Element (3a, 3b, 3c, 3d) fällt, und
die Lichtquelle (5) ist ein Excimerlaser, der ultraviolettes Licht emittiert.

2. Optische Vorrichtung nach Anspruch 1, wobei die Wasserstoffkonzentration des wasserstoffhaltigen Gases so eingestellt ist, dass sie weniger als 4 Volumen-% beträgt.

3. Optische Vorrichtung nach Anspruch 1, wobei der Behälter (2) ferner ein Ventil (6) umfasst, das zum Anschluss an ein externes Element eingerichtet ist, um zumindest Wasserstoff von dem externen Element in den Behälter (2) einzuspeisen.

4. Optische Vorrichtung nach Anspruch 3, wobei das Ventil (6) aus der Gruppe ausgewählt ist, die aus einem Rückschlagventil und einem Absperrventil besteht.

5. Optische Vorrichtung nach Anspruch 1, wobei der Behälter (9) ferner mindestens einen Einlass (7) und mindestens einen Auslass (8) aufweist, wobei das wasserstoffhaltige Gas durch den Behälter (9) von dem mindestens einen Einlass (7) zu dem mindestens einen Auslass (8) strömt.

6. Optische Vorrichtung nach Anspruch 1, wobei das wasserstoffhaltige Gas reiner Wasserstoff ist.

7. Optische Vorrichtung nach Anspruch 1, wobei das optische Element (3a, 3b, 3c, 3d) mindestens eine Linse, eine optische Faser, einen Spiegel, ein Prisma, einen optischen Filter und ein Retikel umfasst.

8. Verfahren zum Bestrahlen eines optischen Elementes (3a, 3b, 3c, 3d) mit ultraviolettem Licht, während das optische Element (3a, 3b, 3c, 3d), das Quarzglas umfasst, vor strahlungsinduzierten Defekten geschützt wird, umfassend die Schritte:
Wärmebehandlung des optischen Elementes (3a, 3b, 3c, 3d) in einer Wasserstoffatmosphäre,
**gekennzeichnet durch** die folgenden Schritte:
Aufnehmen des optischen Elementes (3a, 3b, 3c, 3d) in einen Behälter (2) nach Wärmebehandlung,
Füllen des Behälters (2) mit einem wasserstoffhaltigen Gas nach Aufnahme des optischen Elementes (3a, 3b, 3c, 3d),
Einstellen des Partialdrucks des Wasserstoffs in dem gefüllten Behälter (2) in einem Bereich von 981 Pa bis 49,0 MPa (0,01 bis 500 kgf/cm²), und
Bestrahlen des optischen Elementes (3a, 3b, 3c, 3d) in dem gefüllten Behälter (2) mit ultraviolettem Licht.

9. Verfahren nach Anspruch 8, wobei der Wärmebehandlungsschritt die gleichzeitigen Schritte umfasst:
Einstellen eines Drucks der Wasserstoffatmosphäre von 98,1 KPa bis 49,0 MPa (1 bis 500 kgf/cm²), und
Einstellen einer Temperatur der Wasserstoffatmosphäre von 80 bis 500°C.

10. Verfahren nach Anspruch 8, ferner umfassend den Schritt:
Durchleiten des wasserstoffhaltigen Gases durch den Behälter (2) nach dem Schritt des Füllens des Behälters (2) unter gleichzeitigem Halten des Wasserstoffs bei dem Partialdruck von 981 Pa bis 49,0 MPa (0,01 bis 500 kgf/cm²).

11. Verfahren nach Anspruch 8, ferner umfassend den Schritt:
Abdichten des Behälters (2) nach dem Schritt des Füllens des Behälters (2).

12. Verfahren nach Anspruch 8, ferner umfassend den Schritt:
Einstellen der Konzentration des Wasserstoffs, der den Behälter (2) füllt, bei weniger als 4 Volumen-%.

## Revendications

1. Un appareil optique comprenant :
Un container (2) rempli d'un gaz contenant de l'hydrogène ;
Un élément optique (3a, 3b, 3c, 3d) de verre de silice, installé dans le container (2) ; et
Une source de lumière (5) émettant une lumière cohérente, **caractérisé par** les caractéristiques suivantes :
L'hydrogène a une pression partielle de 981 Pa à 49,0 MPa (0,01 à 500 kgf/cm²);
L'élément optique (3a, 3b, 3c, 3d) et ladite source de lumière (5) sont alignés de sorte que la lumière cohérente émise à partir de la source de lumière (5) soit incidente sur l'élément optique (3a, 3b, 3c, 3d), et
La source de lumière (5) est un laser à excimère émettant une lumière ultraviolette.

2. Un appareil optique selon la revendication 1, où la concentration en hydrogène du gaz contenant de l'hydrogène est inférieure à 4% par volume.

3. Un appareil optique selon la revendication 1, où ledit container (2) comprend de
plus une vanne (6), la vanne (6) étant d'une construction pour la connexion à un élément externe afin de fournir au moins de l'hydrogène à partir de l'élément externe dans ledit container (2).

4. Un appareil optique selon la revendication 3, où la vanne (6) est sélectionnée à partir du groupe se composant d'un clapet de non-retour et d'une soupape d'arrêt.

5. Un appareil optique selon la revendication 1, où le container (9) comprend de plus au moins une entrée (7) et au moins une sortie (8), où le gaz contenant de l'hydrogène coule au travers du container (9) à partir d'au moins cette entrée (7) vers au moins cette sortie (8).

6. Un appareil optique selon la revendication 1, où le gaz contenant de l'hydrogène est de l'hydrogène pur.

7. Un appareil optique selon la revendication 1, où l'élément optique (3a, 3b, 3c, 3d) inclut au moins une lentille, une fibre optique, un miroir, un prisme, un filtre optique, et un réticule.

8. Une méthode d'irradiation d'un élément optique (3a, 3b, 3c, 3d) avec une lumière ultraviolette tout en protégeant l'élément optique (3a, 3b, 3c, 3d) comprenant du verre de silice des défauts induits par radiation, comprenant les étapes de :
Traitement à chaud de l'élément optique (3a, 3b, 3c, 3d), dans une atmosphère d'hydrogène ;
**Caractérisé par** les étapes suivantes :
Installation de l'élément optique (3a, 3b, 3c, 3d) dans un container (2) après un traitement à chaud ;
Remplissage du container (2) avec un gaz contenant de l'hydrogène après installation de l'élément optique (3a, 3b, 3c, 3d) ;
Réglage de la pression partielle de l'hydrogène dans le container rempli (2) pour être dans une fourchette de 981 Pa à 49,0 MPa (0,01 à 500 kgf/cm²), et
Irradiation de l'élément optique (3a, 3b, 3c, 3d) dans le container rempli (2) avec de la lumière ultraviolette.

9. Une méthode selon la revendication 8, où ladite étape de traitement à chaud inclut des étapes contemporaines de :
Réglage d'une pression de l'atmosphère d'hydrogène à 98,1 KPa à 49,0 MPa (1 à 500 kgf/cm²) ;
Réglage d'une température de l'atmosphère d'hydrogène à 80 à 500°C.

10. Une méthode selon la revendication 8, comprenant de plus une étape de :
Ecoulement du gaz contenant de l'hydrogène au travers du container (2), après l'étape de
Remplissage du container (2), tout en maintenant l'hydrogène à la pression partielle de 981 Pa à 49,0 MPa (0,01 à 500 kgf/cm²).

11. Une méthode selon la revendication 8, comprenant de plus une étape de :
Fermeture hermétique du container (2) après l'étape de remplissage du container (2).

12. Une méthode selon la revendication 8, comprenant de plus une étape de :
Réglage de la concentration de l'hydrogène remplissant le container (2) inférieure à 4% par volume.
